# EUROPEAN PATENT APPLICATION

(11) **EP 1 708 357 A1**
(43) Date of publication of application: **04.10.2006**
(21) Application number: 06006380.7
(22) Date of filing: 28.03.2006
(51) Int. Cl.: H03B 5/32

(54) **Highly stable piezoelectric oscillator**

(30) Priority: 29.03.2005 JP 2005095069
(71) Applicant: Epson Toyocom Corporation, Saiwai-ku Kawasaki-shi Kanagawa 212-8513 (JP)
(72) Inventor: Satoh, Tomio, c/o Epson Toyocom Corporation, Kamiina-gun, Nagano-ken 399-4696 (JP)
(74) Representative: HOFFMANN EITLE

(57) **Abstract**

A highly stable piezoelectric oscillator includes a heat-generating component mounted on a base printed circuit board; an erected printed circuit board placed upright on the base printed circuit board by fitting a fitting end part in a fitting slit that is formed to penetrate the base printed circuit board; a piezoelectric resonator which is disposed horizontally and directly on the heat-generating component on the base printed circuit board and whose lead electrode part is connected and fixed on the erected printed circuit board; and an oscillation circuit component to obtain an oscillation output using the piezoelectric resonator as a frequency source. Further, connection pads are arranged opposite from each other on surfaces of the base printed circuit board along both opposing end edges of the fitting slit; arc-shaped side through holes are provided on the inner walls of the fitting slit that correspond to each of the connection pads; and lead pads are arranged so as to have positional relations to their respective connection pads on both surfaces of the fitting end part of the erected printed circuit board; and each connection pad having the side through hole is soldered to each lead pad of the fitting end part.

## Description

### BACKGROUND

### 1. Technical Field

The present invention relates to a highly stable piezoelectric oscillator used as a device such as a frequency control device and, in particular, to improvements of the highly stable piezoelectric oscillator having a structure in which a piezoelectric resonator is heated by a heater and heating temperatures are controlled by a temperature control circuit.

### 2. Related Art

Conventionally, a constant-temperature bath type piezoelectric oscillator is known as a piezoelectric oscillator such as a crystal oscillator, which is a frequency control device used in mobile communication equipment or transmission communication equipment. The constant-temperature bath type piezoelectric oscillator can output highly stable frequencies by heating and controlling the temperatures of the piezoelectric resonator using the heater and the temperature control circuit housed therein, without being affected by external temperature changes.

In recent years, it has been demanded that various types of equipment in these fields be compact, lightweight, and portable. In this respect, the constant-temperature bath type piezoelectric oscillator is also expected to be smaller and lighter.

In order to obtain highly stable frequencies, the conventional constant-temperature bath type piezoelectric oscillator houses a piezoelectric resonator in a recessed portion of a metal block having a large heat capacity and, further, heats the metal block up to a predetermined temperature with a heater. However, because the oscillator uses a large metal block, the volume of the whole oscillator increases and, thus, has not been able to satisfy the size and weight requirements. Further, because the constant-temperature bath type piezoelectric oscillator heats a piezoelectric oscillation element inside the piezoelectric resonator via the metal block, it has been a problem that it takes time for the heat from the heater to reach to the crystal oscillation element and to reach a desired frequency.

As a consequence, a highly stable piezoelectric oscillator has been proposed as shown in a vertical cross-sectional view of Fig. 6A and a plan view of an essential part of Fig. 6B (JP-A-2000-315916, JP-A-2003-37340). This highly stable piezoelectric oscillator 1 is equipped with a first base printed circuit board 2 (a base member) connected directly onto a motherboard of an equipment body (not shown), a second base printed circuit board 10 arranged above and substantially in parallel to the first base printed circuit board 2, and lead pins 3 that electrically and mechanically connect the second base printed circuit board 10 with the first base printed circuit board 2. The highly stable piezoelectric oscillator 1 is further equipped with an erected printed circuit board 20 which is placed upright on the second base printed circuit board 10 by fitting a fitting end part in a fitting slit 11 that is formed to penetrate the second base printed circuit board 10, a piezoelectric resonator 40 which is disposed horizontally and directly on a heat-generating component (a power transistor, a heater, etc.) 30 on the second base printed circuit board 10 and whose lead electrode part is connected and fixed onto the erected printed circuit board 20, the second base printed circuit board 10, and/or an oscillation circuit mounted on the erected printed circuit board 20, circuit components 50 composing a temperature control circuit for energization control of the heater, thermistors 51, etc.

The lead pins 3 penetrate through holes 10a formed in the second base printed circuit board 10 and are connected and fixed to the through hole of the motherboard (not shown) in a state that they are fitted in through holes 2a formed in the first base printed circuit board 2 by using the protruding lower end parts of the lead pins 3. In order to secure space between the first and second base printed circuit boards 2 and 10, washers 15 fitted to the outer peripheries of the lead pins 3 or spacers incorporated in advance with the lead pins 3 are used.

In order to increase airtightness, a cap-like metal oscillator case 60 covers the second base printed circuit board 10 so as to surround each component on the second base printed circuit board 10, and the inner walls of the hem of the oscillator case 60 are attached and fixed to the outer periphery surface of the second base printed circuit board by solder or a resin adhesive.

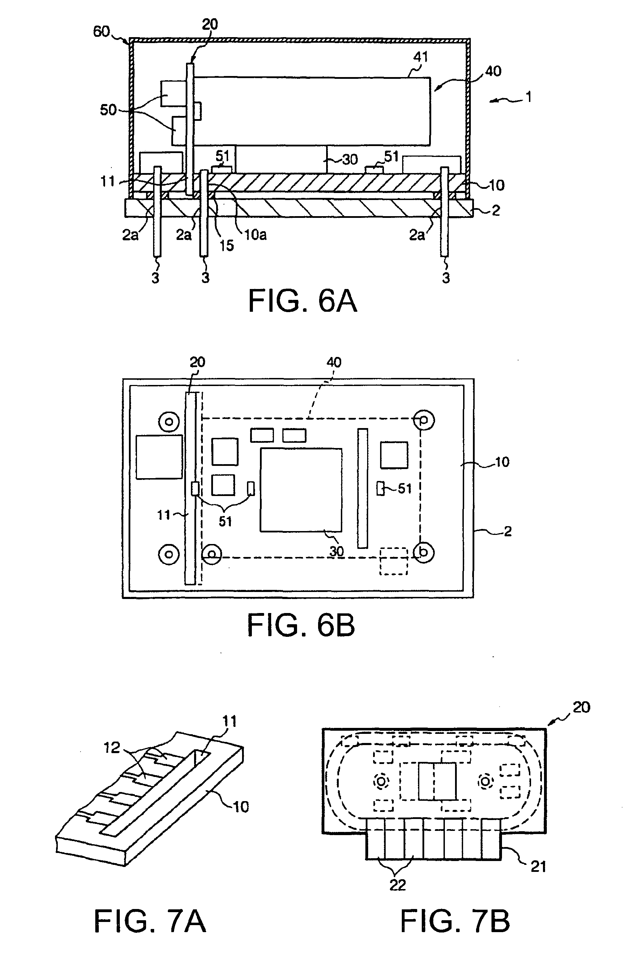

Fig. 7A is a perspective view of a structure of the fitting slit provided in the second base printed circuit board, and Fig. 7B is a side elevation view of Fig. 7A. As shown in Fig. 7A, a plurality of connection pads 12 are formed on the board surface along one end edge, out of two opposing end edges, of the fitting slit 11. As shown in Fig. 7B, a fitting end part 21 is formed at the bottom side of the erected printed circuit board 20 to match and fit in the fitting slit 11, and, on one surface of the fitting end part 21, lead pads 22 are formed in positions corresponding to the respective connection pads 12. In a state that the fitting end part 21 of the erected printed circuit board is fitted in the fitting slit 11 so that each connection pad 12 opposes the respective lead pad 22, each connection pad 12 and each lead pad 22 put close to each other are connected by solder so that the erected printed circuit board 20 is fixed on the second base printed circuit board 10.

However, because the erected printed circuit board 20 is supported on the second base printed circuit board 10 depending only on the connection force of the soldering, as well as to the fitting and holding force of the fitting slit 11, and because the amount of solder to be used is limited, there is not enough strength in the connection. Since the connected portion connected by the soldering peels off, there are many cases in which this oscillator is not able to function as the oscillator.

### SUMMARY OF THE INVENTION

In the highly stable piezoelectric oscillator having a structure in which the piezoelectric resonator is heated by the heater and heating temperatures are controlled by the temperature control circuit, an advantage of the invention is to provide a more reliable, highly stable piezoelectric oscillator by enhancing holding stability when joining a base printed circuit board onto a printed circuit board that supports a piezoelectric resonator in a state that the printed circuit board is placed upright against the base printed circuit board.

An aspect of the invention is a highly stable piezoelectric oscillator having a heat-generating component mounted on a base printed circuit board, an erected printed circuit board placed upright on the base printed circuit board by fitting a fitting end part in a fitting slit that is formed to penetrate the base printed circuit board, a piezoelectric resonator which is disposed horizontally and directly on the heat-generating component on the base printed circuit board and whose lead electrode part is connected and fixed on the erected printed circuit board, and an oscillation circuit component to obtain an oscillation output using the piezoelectric resonator as a frequency source, in that: connection pads are arranged opposite from each other on surfaces of the base printed circuit board along both opposing end edges of the fitting slit; arc-shaped side through holes are provided on the inner walls of the fitting slit that correspond to each of the connection pads; and lead pads are arranged so as to have positional relations to their respective connection pads on both surfaces of the fitting end part of the erected printed circuit board; and each connection pad having the side through hole is soldered to each lead pad of the fitting end part.

It is preferable that the base printed circuit board is arranged above and substantially parallel to a tabular base member while keeping a predetermined gap therefrom, and that a cap-like case covers the base member so as to surround the base printed circuit board and components mounted thereon.

It is also preferable that the base member and the base printed circuit board are fixed with a lead pin, and that a spacer that maintains a gap between the base member and the base printed circuit board is either fitted in the lead pin or incorporated in advance with the lead pin.

It is further preferable that surface mounting is made possible by including a side through hole on a side surface of the base member and a mounting pad electrode that communicates with the side through hole on a bottom surface of the base member.

With the conventional highly stable piezoelectric oscillator having the structure in which the piezoelectric resonator is heated by the heater and the heating temperatures are controlled by the temperature control circuit, the number of connection pads and the total area of the connection pads are insufficient when joining the erected printed circuit board onto the base printed circuit board that supports the piezoelectric resonator. Thus, sufficient amount of the solder cannot be secured, holding stability when placing the printed circuit board upright is not enough, and the electrical connection is not very reliable. To increase the holding strength, reinforcement jigs such as pins of a special kind need to be used, and they become a cause of enlargement of the assembled structure. According to the aspect of the invention, the total area of the connection pads and the amount of the solder increase by increasing the number of the connection pads, and the amount of the solder to be used increases by providing the side through holes, and, accordingly, the highly stable piezoelectric oscillator may become more reliable as the stability in holding the erected printed circuit board becomes greater.

### BRIEF DESCRIPTION OF THE DRAWINGS

The invention will be described with reference to the accompanying drawings, wherein like numbers reference like elements.

Fig. 1A is a perspective diagram showing a structure of a fitting slit part of a second base printed circuit board.

Fig. 1B is a plan view of Fig 1A.

Fig. 2A is an elevation view of a structure of an erected printed circuit board.

Fig. 2B is a side elevation view of Fig. 2A.

Fig. 3A is a perspective diagram showing a situation in which the erected printed circuit board is fitted in and connected to the second base printed circuit board.

Fig. 3B is a cross-sectional view of Fig. 3A.

Fig. 4 is a diagram to explain an installation structure of a lead pin in an oscillator shown in Fig. 6.

Figs. 5A and 5B are diagrams showing working examples having structures that allow surface mounting of an oscillator on a motherboard (not shown).

Fig. 6A is a vertical cross-sectional view of a conventional example.

Fig. 6B is a plan view of an essential part of Fig. 6A.

Fig. 7A is a perspective view showing a structure of the fitting slit provided in the second base printed circuit board.

Fig. 7B is a side elevation view of Fig. 7A.

### DESCRIPTION OF EXEMPLARY EMBODIMENT

An embodiment of the invention will now be described. The whole composition of the oscillator shown in Figs. 6A and 6B will also be referred to in the descriptions.

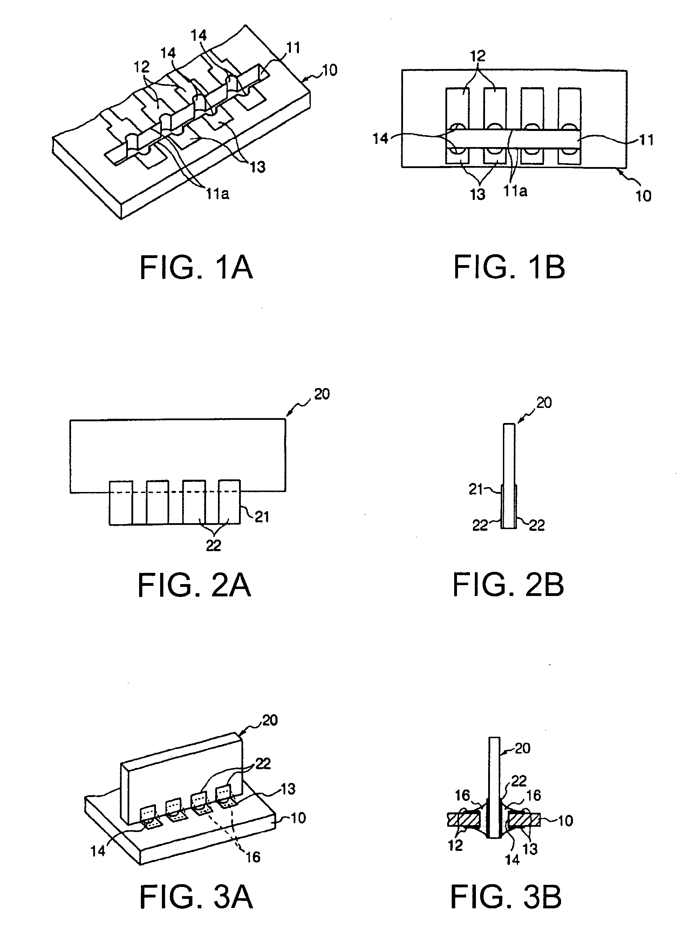

Fig. 1A is a perspective diagram showing a structure of a fitting slit part of a second base printed circuit board, and Fig. 1B is a plan view of Fig. 1A. Fig. 2A is an elevation view of a structure of an erected printed circuit board, and Fig. 2B is a side elevation view of Fig. 2A. Fig. 3A is a perspective diagram showing a situation in which the erected printed circuit board is fitted in and soldered to the second base printed circuit board, and Fig. 3B is a cross-sectional view of Fig. 3A.

A long, thin, rectangular fitting slit 11 is formed to penetrate a second base printed circuit board as 10 shown in Figs. 1A and 1B. Connection pads 12 and 13 are disposed opposite from each other on the surface of the second base printed circuit board along two opposing end edges (in a longitudinal direction) of this fitting slit 11. The connection pads 12 formed along one end edge are connected to another circuit pattern. The connection pads 13 formed along the other end edge are, in this case, not connected to another circuit pattern but are disposed so as to be soldered to lead pads on an erected printed circuit board 20 side. Further, arc-shaped side through holes 14 are formed on the inner walls of the fitting slit that correspond to each of the connection pads 12 and 13. The side through holes 14A include conductive films formed on their inner walls of the arced notches, and each of the conductive films communicates with each of the connection pads 12 and 13. When necessary, the connection pads may be disposed on the lower surface of the second base printed circuit board along the end edges of the fitting slit 11 so as to be connected to lead pads 22 of the erected printed circuit board 20 which will be described hereafter.

The erected printed circuit board 20 has a fitting end part 21 protruding from the lower end edge thereof. On both surfaces of the fitting end part 21, the lead pads 22 are arranged so as to have positional relations to their respective connection pads 12 and 13. Thus, in a state in which the fitting end part 21 of the erected printed circuit board 20 is fitted in the fitting slit 11 of the second base printed circuit board 10, each of the connection pads 12 and 13 corresponds one-on-one to each lead pad 22, and the surface of each of the lead pads 22 opposes each of the side through holes 14 formed on the inner walls of the fitting slit. While the two boards are fitted together, solder 16 is applied between the connection pads 12 and 13 and the lead pads 22 as shown in Figs. 3A and 3B, melted, and then cured so that both boards become electrically and mechanically fixed. In comparison with the conventional structure of the joined boards as shown in Figs. 7A and 7B, it is not only that the number of the connection pads to be soldered to the lead pads doubles but that a large amount of solder can be filled in the side through holes 14. Accordingly, the connection between the boards becomes stronger and more reliable.

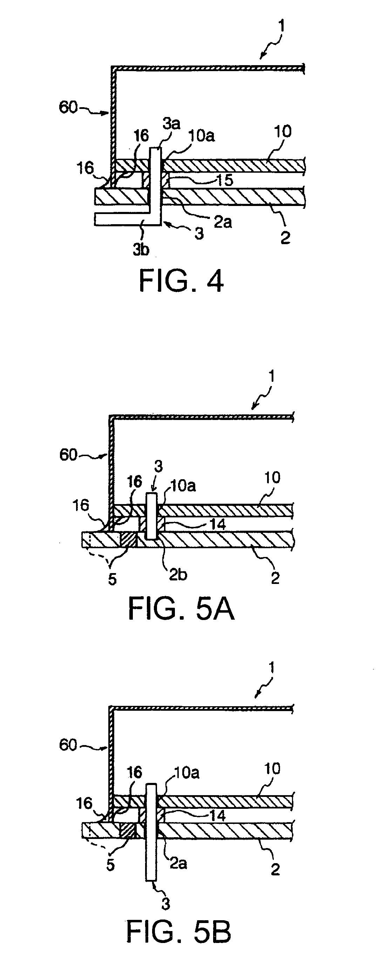

Fig. 4 is a diagram to explain an installation structure of a lead pin in the oscillator shown in Figs. 6A and 6B. A lead pin 3 is composed of a straightly formed upper part 3a and a lower part 3b that is bent at the bottom end part thereof and then stretched laterally. The oscillator 1 is mounted in a state that the upper part 3a penetrates through holes (support holes) 2a and 10a that are formed on both base printed circuit boards 2 and 10, respectively, and that the laterally stretched lower part 3b is soldered to a connection pad on a mother board (not shown).

Figs. 5A and 5B are working examples having structures that allow surface mounting of the oscillator 1 on a motherboard (not shown). In the example of Fig. 5A, the straight-shaped lead pin 3 penetrates the through hole 10a provided in the second base printed circuit board 10, and the lower end part of the lead pin 3 is fitted and set in a recessed support hole 2b which is provided in the upper surface of a first base printed circuit board 2 in such a manner that the lead pin 3 does not penetrate the first base printed circuit board 2. Further, side through holes 5 are formed on the outer periphery surface of the first base printed circuit board 2, and, on the bottom surface of the first base printed circuit board 2, mounting pad electrodes communicating with the side through holes 5 are formed. Using these side through holes 5 and carrying out the connection by soldering, the oscillator 1 is surface-mounted on a circuit pattern on the motherboard.

The example of Fit. 5B employs a mounting structure of the oscillator 1 mounted on the motherboard using the lead pins 3, in addition to employing the surface mounting structure using the side through holes 5 as shown in Fig. 5A. That is, the oscillator of Fig. 5B has a structure in that the oscillator is soldered and fixed to wiring pattern on the motherboard using the side through holes 5 provided on the side surface of the first base printed circuit board 2, while the lower end parts of the lead pins 3 penetrate and protrude below the through holes 2a made in the first base printed circuit board 2. By inserting the lower end parts of the lead pins 3 through the corresponding through holes made on the motherboard, the oscillator can be soldered and fixed. As a consequence, it becomes possible to further increase the mounting strength and connection stability of the oscillator mounted on the motherboard.

Additionally, for the heat-generating component on the second base printed circuit board 10, we have confirmed that a power MOSFET (e.g., of LFPAK type by Hitachi Ltd.), which is a surface-mounting type (SOP package) thin power transistor having a heat sink on its upper surface, shows high heat efficiency and is suitable for miniaturization.

## Claims

1. A highly stable piezoelectric oscillator comprising
a heat-generating component mounted on a base printed circuit board;
an erected printed circuit board placed upright on the base printed circuit board by fitting a fitting end part in a fitting slit that is formed to penetrate the base printed circuit board;
a piezoelectric resonator that is disposed horizontally and directly on the heat-generating component on the base printed circuit board and whose lead electrode part is connected and fixed on the erected printed circuit board; and
an oscillation circuit component to obtain an oscillation output using the piezoelectric resonator as a frequency source, wherein:
connection pads are arranged opposite from each other on surfaces of the base printed circuit board along both opposing end edges of the fitting slit, and arc-shaped side through holes are provided on the inner walls of the fitting slit that correspond to each of the connection pads;
lead pads are arranged so as to have positional relations to their respective connection pads on both surfaces of the fitting end part of the erected printed circuit board; and
each connection pad having the side through hole is soldered to each lead pad of the fitting end part.
2. The highly stable piezoelectric oscillator according to Claim 1, wherein the base printed circuit board is arranged above and substantially parallel to a tabular base member while keeping a predetermined gap therefrom; and a cap-like case covers the base member so as to surround the base printed circuit board and components mounted thereon.
3. The highly stable piezoelectric oscillator according to Claim 1, wherein the base member and the base printed circuit board are fixed with a lead pin; and a spacer that maintains a gap between the base member and the base printed circuit board is either fitted to the lead pin or incorporated in advance with the lead pin.
4. The highly stable piezoelectric oscillator according to Claim 1, wherein surface mounting is made possible by including a side through hole on a side surface of the base member and a mounting pad electrode that communicates with the side through hole on a bottom surface of the base member.
